(19) Europäisches Patentamt
European Patent Office
Office européen des brevets

(11) **EP 2 507 834 B1**

(12) **EUROPÄISCHE PATENTSCHRIFT**

(45) Veröffentlichungstag und Bekanntmachung des Hinweises auf die Patenterteilung:
**22.10.2014 Patentblatt 2014/43**

(51) Int Cl.:
*H01L 31/18* (2006.01)     *H01L 27/142* (2014.01)
*B23K 26/36* (2014.01)     *B23K 26/40* (2014.01)

(21) Anmeldenummer: **10787692.2**

(22) Anmeldetag: **29.11.2010**

(86) Internationale Anmeldenummer:
**PCT/EP2010/007221**

(87) Internationale Veröffentlichungsnummer:
**WO 2011/066930 (09.06.2011 Gazette 2011/23)**

(54) **VERFAHREN ZUM ZUMINDEST BEREICHSWEISEN ENTFERNEN EINER SCHICHT EINES SCHICHTENSTAPELS**

METHOD FOR REMOVING AT LEAST SECTIONS OF A LAYER OF A LAYER STACK

PROCÉDÉ POUR ENLEVER AU MOINS DANS CERTAINES ZONES UNE COUCHE D'UN EMPILEMENT DE COUCHES

(84) Benannte Vertragsstaaten:
**AL AT BE BG CH CY CZ DK EE ES FI FR GB GR HR HU IE IS IT LI LT LU LV MC MK MT NL NO PL PT RO RS SE SI SK SM TR**

(30) Priorität: **01.12.2009 DE 102009056572**

(43) Veröffentlichungstag der Anmeldung:
**10.10.2012 Patentblatt 2012/41**

(73) Patentinhaber: **Manz AG**
**72768 Reutlingen (DE)**

(72) Erfinder:
 • **MOLDOVAN, Vasile Raul**
   **70597 Stuttgart (DE)**
 • **NEUGEBAUER, Christoph Tobias**
   **73230 Kirchheim/Teck (DE)**

(74) Vertreter: **Kohler Schmid Möbus**
**Patentanwälte**
**Kaiserstrasse 85**
**72764 Reutlingen (DE)**

(56) Entgegenhaltungen:
**EP-A1- 2 083 445     EP-A2- 1 020 934**
**EP-A2- 2 214 213     DE-A1- 10 326 505**
**DE-B4- 19 964 443     JP-A- 7 099 335**

• **QUERCIA L ET AL: "Laser patterning of CuInSe2/Mo/SLS structures for the fabrication of CuInSe2 sub modules", MATERIALS SCIENCE FORUM SWITZERLAND, Bd. 173-174, 1995, Seiten 53-58, XP008134946, ISSN: 0255-5476**
• **HERMANN J ET AL: "Comparative investigation of solar cell thin film processing using nanosecond and femtosecond lasers; Solar cell thin film processing", JOURNAL OF PHYSICS D. APPLIED PHYSICS, IOP PUBLISHING, BRISTOL, GB, Bd. 39, Nr. 3, 7. Februar 2006 (2006-02-07), Seiten 453-460, XP020095014, ISSN: 0022-3727, DOI: DOI:10.1088/0022-3727/39/3/005**
• **COMPAAN A D ET AL: "Laser scribing of polycrystalline thin films", OPTICS AND LASERS IN ENGINEERING JULY 2000 ELSEVIER SCIENCE LTD, Bd. 34, Nr. 1, Juli 2000 (2000-07), Seiten 15-45, XP002630780, DOI: DOI: 10.1016/S0143-8166(00)00061-0**

**Beschreibung**

Die Erfindung betrifft ein Verfahren mit den Merkmalen des Oberbegriffs des Anspruchs 1.

Es ist bekannt, dass Dünnschicht-Solarzellen aus unterschiedlichen Schichten aufgebaut sind und somit einen Schichtenstapel darstellen. Häufig ist auf einem optisch transparenten Substrat eine elektrisch leitfähige Schicht aufgebracht, auf der sich wiederum eine Halbleiterschicht befindet. Als oberste Schicht ist wiederum eine elektrisch leitfähige Schicht vorgesehen.

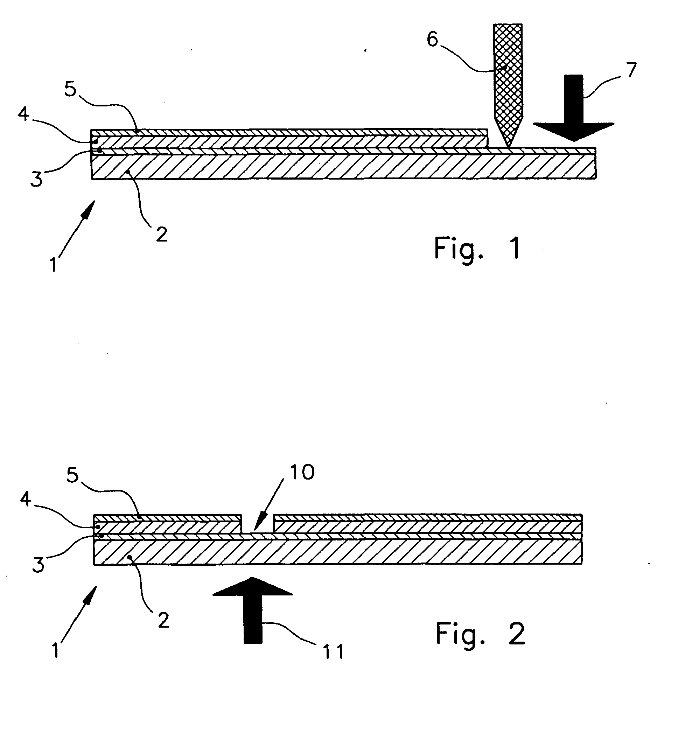

Während der Herstellung müssen Dünnschicht-Solarzellen strukturiert werden. Dies erfolgt zum Beispiel bei CIS/CIGS-Zellen durch einen mechanischen Stichel oder einen Picosekunden- (ps-)Laser. Diese Bearbeitung erfolgt in der Regel von oben, also von der oberen elektrisch leitfähigen Schicht aus. Dies wird anhand der Fig. 1 erläutert:

Die Fig. 1 zeigt einen Schichtenstapel 1, umfassend ein Glassubstrat 2, auf dem eine elektrisch leitfähige Schicht 3 (Metallisierungsschicht), beispielsweise aus Molybdän, angeordnet ist. Darauf folgt eine Halbleiterschicht 4, beispielsweise eine Kupferindiumselen (CIS)- oder Kupferindiumgalliumselen (CIGS)-Schicht. Auf der Halbleiterschicht 4 ist wiederum eine elektrisch leitfähige Schicht 5, beispielsweise aus TCO (Transparent Conductive Oxide) aufgebracht. Mit der Bezugsziffer 6 ist ein mechanischer Stichel angedeutet, der dazu verwendet werden kann, Spuren einzubringen.

Um auf einem Substrat mehrere Einzelsolarzellen herzustellen, die in Serie miteinander verschaltet werden können, wird eine so genannte P2-Spur aufgebracht, d. h. die Schicht 4 bereichsweise entfernt. Die dann aufgebrachte Schicht 5 (Frontseitenkontakt) stellt dann eine elektrische Verbindung zu Schicht 3 (Rückseitenkontakt) her. Anschließend wird eine P3-Spur eingebracht, indem die Schichten 4 und 5 bereichsweise entfernt werden. Durch diesen Schritt sollen Einzelzellen getrennt werden. Eine elektrische Verbindung zwischen den Schichten 3 und 5 darf an dieser Stelle nicht erfolgen.

Problematisch bei der Verwendung eines mechanischen Stichels ist, dass durch diesen nur relativ breite Spuren eingebracht werden und dass der Stichel sich abnutzen kann. Außerdem ist dieses Verfahren relativ langsam.

Alternativ oder zusätzlich kann eine Strukturierung (Spureinbringung) mittels eines Picosekundenlasers, wie dies durch die Bezugsziffer 7 angedeutet ist, erfolgen. Picosekundenlaser sind jedoch sehr teuer in der Anschaffung.

Beide Strukturierungsverfahren erfolgen gemäß dem Stand der Technik von oben, also von der dem Substrat 2 abgewandten Seite her. Insbesondere bei der Strukturierung mittels Laser kann es vorkommen, dass die elektrisch leitfähige Schicht 5 aufgeschmolzen wird und an den Rändern der Strukturierung nach unten fließt. Außerdem erhöht sich in der Halbleiterschicht 4 innerhalb der Wärmeeinflusszone durch thermische Effekte die elektrische Leitfähigkeit signifikant, sodass durch beide Effekte ein Kurzschluss zur elektrisch leitfähigen Schicht 3 erfolgen kann. Dies sollte nach Möglichkeit vermieden werden.

Außer der Strukturierung, also dem Einbringen von Spuren mittels mechanischem Stichel oder Picosekundenlaser, erfolgt häufig eine so genannte Randentschichtung, also eine Isolierung am Rand der Solarzelle. Dies ist beispielsweise in der DE 199 644 43 B4 beschrieben.

Aus der EP 2 083 445 A1 ist ein Verfahren zur Herstellung eines photovoltaischen Moduls bekannt. Zur Bildung serienverschalteter Zellen werden die transparente Grundelektrodenschicht, die Halbleiterschicht und die Rückelektrodenschicht durch Trennlinien mit einem Laser, der eine infrarote Strahlung emittiert, strukturiert. Die Strukturierung der Halbleiterschicht und der Rückelektrodenschicht erfolgt von der Substratseite her, indem Laserlicht durch die transparente Frontelektrode hindurch zur Halbleiterschicht und Rückelektrodenschicht geleitet wird.

Die EP 1 727 211 A1 offenbart ein Verfahren zur Strukturierung einer Dünnschichtsolarzelle. Mit Laserlicht einer ersten Leistung werden eine Halbleiterschicht und eine darauf angeordnete Rückelektrodenschicht entfernt, indem Laserlicht durch das transparente Substrat und die transparente darauf angeordnete Frontelektrode hindurch zur zu entfernenden Halbleiterschicht und Rückelektrodenschicht geleitet wird. Mit Laserlicht einer zweiten Leistung werden die Schichten, die auf dem Substrat angeordnet sind, entfernt, indem das Laserlicht durch das transparente Substrat hindurch zu dem zu entfernenden Schichtenstapel geleitet wird.

Die DE 20 2008 005 970 U1 offenbart eine Vorrichtung zum Abtragen von Schichten auf Glas mittels Laserstrahlung bei einer Dünnschichtsolarzelle, bei der der Laser durch Güteschaltung des Resonators kurze Pulse erzeugt, und bei der mit der Strahlung des Lasers Brennflecken auf der Schicht erzeugt werden, die durch Stellvorrichtungen aneinandergereiht werden, sodass ein flächiger Abtrag erfolgt.

Quercia L et al: "Laser patterning of CuInSe2/Mo/SLS structures for the fabrication of CuInSe2 sub modules", Materials Science Forum Switzerland, Bd. 173 - 174, 1995, Seiten 53 - 58, offenbart ausschließlich, eine Vorderseite oder von der Halbleiterseite her kommende Strukturierung. Weiter ist beschrieben, eine Molybdänschicht vom Substrat durch Einstrahlung von der Glasseite her zu entfernen.

Hermann J et al: "Comparative investigation of solar cell thin film processing using nanosecond and femtosecond lasers; Solar cell thin film processing", Journal of Physics D, Applied Physics, IOP Publishing, Bristol, GB, Bd. 39, Nr. 3, 7. Februar 2006, Seiten 453 - 460, beschreibt unterschiedliche Versuche, mit unterschiedlichen Laserpulsen eine oder mehrere Schichten eines Schichtenstapels zu entfernen.

Ein bekanntes Verfahren zur Strukturierung ist in EP 2 083 445 A1 offenbart.

Aufgabe der vorliegenden Erfindung ist es, ein Verfahren bereitzustellen, mit dem auf einfache und kostengünstige Art und Weise eine oder mehrere Schichten eines Schichtenstapels bereichsweise entfernt werden kann. Wenn das Verfahren auf Solarzellen angewandt wird, soll auch die Ausbildung von Kurzschlüssen zwischen elektrisch leitenden Schichten durch dieses Verfahren vermieden werden.

Gelöst wird diese Aufgabe durch ein Verfahren mit den Merkmalen des Anspruchs 1. Vorzugsweise wird dabei die optisch dichte Metallisierungsschicht, die vorteilhafterweise eine höhere Wärmeleitfähigkeit und/oder einen höheren Siedepunkt aufweist als der Siedepunkt zumindest eines Bestandteils der darüber liegenden Halbleiterschicht, in den Bereichen erwärmt, in denen die darüber liegende Halbleiterschicht entfernt werden soll.

Soll also beispielsweise eine Spur in die Halbleiterschicht eingebracht, diese also entfernt werden, so wird die optisch dichte Halbleiterschicht entlang des Verlaufs dieser Spur erwärmt. Dadurch, dass die optisch dichte Metallisierungsschicht so erwärmt wird, dass zumindest ein Bestandteil mit niedrigerem Siedepunkt der darüber liegenden Halbleiterschicht verdampft, kommt es zu einer Entfernung der Halbleiterschicht und ggf. von Schichten, die oberhalb der Halbleiterschicht liegen. Handelt es sich bei der Halbleiterschicht um eine CIS- oder CIGS-Schicht, kann es ausreichend sein, durch eine Erwärmung der darunter liegenden Metallisierungsschicht das Selen (Siedepunkt: 684,6 °C, Wärmeleitfähigkeit $2\dfrac{w}{mK}$ )

in der Halbleiterschicht zum Verdampfen zu bringen. Ein Verdampfen weiterer Bestandteile der Halbleiterschicht ist jedoch auch denkbar. Das Verdampfen nur eines Bestandteils der Halbleiterschicht ist in der Regel ausreichend, um ein Abplatzen der restlichen Bestandteile der Schicht und eventuell darüber liegender Schichten zu verursachen. Grundsätzlich ist es auch denkbar, die optisch dichte Schicht so zu erwärmen, dass es aufgrund von Temperaturunterschieden zwischen optisch dichter Schicht und Halbleiterschicht zu einem lokalen Abplatzen der Halbleiterschicht und ggfs. darüber angeordneter Schichten kommt, also ohne dass ein Bestandteil der Halbleiterschicht verdampft.

Bei dieser Art der Entfernung der Halbleiterschicht bzw. der darüber liegenden Schichten entstehen Risskanten. Dadurch wird die Gefahr von Kurzschlüssen zwischen einer Deckelektrodenschicht (elektrisch leitfähige Schicht, die über der Halbleiterschicht angeordnet ist, Frontseitenkontakt bei einer Solarzelle) und der optisch dichten Metallisierungsschicht, die eine erste Metallisierungsschicht einer Solarzelle sein kann, verringert.

Die optisch dichte Metallisierungsschicht wird von der der Halbleiterschicht abgewandten Seite her erwärmt. Dadurch kann vermieden werden, dass eine elektrisch leitfähige Schicht (Deckelektrodenschicht), die auf der Halbleiterschicht angeordnet ist, aufgeschmolzen wird und ein Kurzschluss zu der optisch dichten Metallisierungsschicht hergestellt wird. Die optisch dichte Metallisierungsschicht kann als Molybdänschicht ausgebildet sein (Siedepunkt: 4639 °C, Wärmeleitfähigkeit: 138

$$\dfrac{W}{mK} ).$$

Die optisch dichte Metallisierungsschicht wird durch eine oder mehrere optisch transparente Schichten hindurch erwärmt. Beispielsweise kann die optisch dichte Metallisierungsschicht auf einem Glassubstrat angeordnet sein und durch das Glassubstrat hindurch erwärmt werden. Zusätzlich zu einem optisch transparenten Substrat können unterhalb der optisch dichten Metallisierungsschicht noch weitere transparente Schichten, insbesondere Haftvermittlerschichten oder Diffusionsbarrieren, vorgesehen sein. Auch durch diese Schichten hindurch kann die optisch dichte Metallisierungsschicht, die beispielsweise als Molybdänschicht ausgebildet sein kann, erhitzt werden.

Die Erwärmung erfolgt mittels eines Lasers. Dadurch ist es besonders einfach, eine Erwärmung durch eine optisch transparente Schicht hindurch durchzuführen.

Während es gemäß dem Stand der Technik notwendig ist, einen Picosekundenlaser zu verwenden, der in der Anschaffung sehr teuer ist, ist erfindungsgemäß vorgesehen, die Erwärmung mittels eines Nanosekundenlasers durchzuführen. Insbesondere können Infrarotlaser im Bereich von 1 μm verwendet werden. Derartige Laser sind erheblich günstiger als Picosekundenlaser.

Weitere Vorteile ergeben sich, wenn die Erwärmung mittels eines gepulsten Lasers erfolgt. Dadurch kann der Energieeintrag gut dosiert werden. Insbesondere kann dadurch eine punktförmige Erwärmung der optisch dichten Schicht erfolgen. Die Ausdehnung der abgeplatzten zweiten Schicht kann dadurch besonders gut kontrolliert werden.

Besonders bevorzugt ist es, wenn der Laserstrahl mittels eines im Querschnitt quadratischen oder runden optischen Lichtleiters auf den Schichtenstapel abgebildet wird. Durch diese Maßnahme können besonders gut definiert Spuren in den Schichtenstapel eingebracht werden.

Weiterhin kann vorgesehen sein, dass die optisch dichte Schicht derart erwärmt wird, dass diese verdampft. Es versteht sich, dass, ehe die optisch dichte Schicht verdampft, die darüber liegende Halbleiterschicht verdampft. Das Verdampfen der optisch dichten Schicht ist besonders vorteilhaft, wenn eine Randentschichtung von Solarzellen, insbesondere Dünnschicht-Solarzellen, durchgeführt werden soll.

Besondere Vorteile ergeben sich, wenn das erfindungsgemäße Verfahren zur Randentschichtung einer Solarzelle oder zur Solarzellenstrukturierung, insbesondere von Dünnschicht-Solarzellen, verwendet wird.

Weitere Merkmale und Vorteile der Erfindung ergeben sich aus der nachfolgenden detaillierten Beschreibung von Ausführungsbeispielen der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

Es zeigen:

Fig. 1    einen Schichtenstapel, der gemäß einem Verfahren des Standes der Technik strukturiert wurde;

Fig. 2    zeigt einen Schichtenstapel, bei dem eine Strukturierung der Oberfläche des Schichtenstapels von der Rückseite des Schichtenstapels her durchgeführt wurde,

Fig. 3    zeigt einen Schichtenstapel, bei dem eine Randentschichtung durchgeführt wurde.

Die Fig. 2 zeigt einen Schichtenstapel 1 mit einem Substrat 2, welches optisch transparent ist. Auf dem Substrat 2 ist eine optisch dichte Schicht 3, beispielsweise aus Molybdän, angeordnet. Bei der Schicht 3 handelt es sich um eine elektrisch leitfähige Schicht, insbesondere eine Metallisierungsschicht. Auf der optisch dichten Schicht 3 ist eine Halbleiterschicht 4, beispielsweise aus CIGS, angeordnet. Auf der Schicht 4 ist wiederum eine elektrisch leitfähige Schicht 5 (Deckelektrodenschicht), beispielsweise aus TCO, aufgebracht.

An der Stelle 10 wurden die Schichten 4, 5 entfernt. Insbesondere wurde hier eine Spur im Rahmen einer so genannten P3-Strukturierung eingebracht. Diese Strukturierung erfolgte, indem durch das transparente Substrat 2 hindurch die Metallisierungsschicht, also die optisch dichte Schicht 3, lokal erwärmt wurde. Insbesondere erfolgte die Erwärmung derart, dass ein Bestandteil der Halbleiterschicht 4, in diesem Fall Selen, verdampfte. Dadurch platzte im Bereich 10 ein Teil des Schichtenstapels, nämlich die Schichten 4, 5, ab. Zur Erwärmung der optisch dichten Schicht 3 wurde ein Nanosekundenlaser verwendet. Dies ist durch die Bezugsziffer 11 angedeutet.

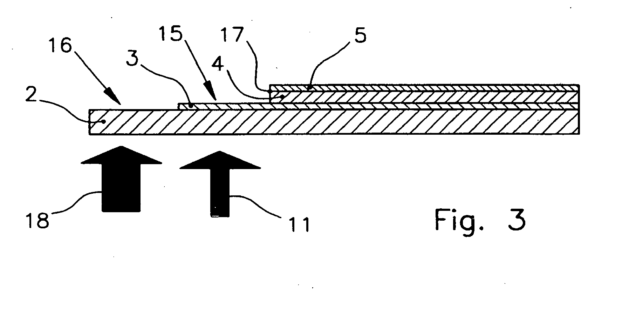

In der Fig. 3 ist wiederum der Schichtenstapel 1 gezeigt. Hier ist zu erkennen, dass im Bereich 15 die Schichten 4, 5 entfernt wurden und im Bereich 16 außerdem die optisch dichte Schicht 3 entfernt wurde. Im Bereich 15 wurden die Schichten 4, 5 auf die gleiche Art und Weise entfernt, wie die Spur im Bereich 10 in der Fig. 2 eingebracht wurde, nämlich indem mit einem Nanosekundenlaser 11 die optisch dichte Schicht 3 erwärmt wurde, sodass ein Bestandteil der Schicht 4, z. B. das Selen, in der Schicht 4 verdampfte und dadurch im Bereich 15 die Schichten 4, 5 abgeplatzt sind. Bei dieser Vorgehensweise entsteht eine gut definierte Risskante 17.

Zur Entfernung der optisch dichten Schicht 3 im Bereich 16 wurde diese mit größerer Laserleistung, was durch den breiter dargestellten Laser 18 angedeutet wird, erwärmt, sodass die Schicht 3 geschmolzen und verdampft ist. Auf diese Art und Weise wurde eine Randentschichtung durchgeführt.

Durch die Fig. 2, 3 wird deutlich, dass mit demselben Laser, der mit unterschiedlichen Leistungen betrieben wird, unterschiedliche Schichtentfernungsergebnisse erzielt werden können. Beispielsweise kann ein Laser zur Strukturierung, wie dies in der Fig. 2 dargestellt ist, nur mit einem geringen Prozentsatz seiner Leistung betrieben werden. Um die optisch dichte Schicht 3 freizulegen, wie dies durch den Bereich 15 in der Fig. 3 angedeutet ist, kann der Laser beispielsweise in einem etwas höheren Leistungsbereich betrieben werden. Wenn jedoch zusätzlich auch noch die optisch dichte Schicht 3 entfernt werden soll, kann der Laser mit einem höheren Prozentsatz seiner Maximalleistung betrieben werden. Somit kann mit nur einem einzigen Laser je nach Laserleistung eine unterschiedliche Schichtentfernung stattfinden.

Aus der Beschreibung der Fig. 2 und 3 wird klar, dass die Vorteile des erfindungsgemäßen Verfahrens insbesondere bei der Herstellung von Solarzellen, insbesondere bei deren Strukturierung und Randentschichtung, liegen.

**Patentansprüche**

1.  Verfahren zum zumindest bereichsweisen Entfernen zumindest einer als CIS oder CIGS ausgebildeten Halbleiterschicht (4) eines Schichtenstapels (1), der eine Halbleiterschicht (4), eine optisch dichte Metallisierungsschicht (3) und auf der der Halbleiterschicht (4) abgewandten Seite gegebenenfalls eine oder mehrere optisch transparente Schichten (2) aufweist, bei dem die optisch dichte Metallisierungsschicht (3) derart erwärmt wird, dass die darüber liegende Halbleiterschicht abgelöst wird, wobei die optisch dichte Metallisierungsschicht (3) von der der Halbleiterschicht (4) abgewandten Seite her gegebenenfalls durch eine oder mehrere optisch transparente Schichten (2) hindurch erwärmt wird, wobei die Erwärmung mittels eines Lasers (11, 18) erfolgt.

2.  Verfahren nach Anspruch 1, **dadurch gekennzeichnet, dass** die optisch dichte Metallisierungsschicht (3) derart erwärmt wird, dass zumindest ein Bestandteil mit geringerer Wärmeleitfähigkeit und/oder geringerem Siedepunkt der darüber liegenden Halbleiterschicht (4) verdampft.

**3.** Verfahren nach einem der vorhergehenden Ansprüche, **dadurch gekennzeichnet, dass** die Erwärmung mittels eines ns-Lasers (11, 18) erfolgt.

**4.** Verfahren nach einem der vorhergehenden Ansprüche, **dadurch gekennzeichnet, dass** die Erwärmung mittels eines gepulsten Lasers (11, 18) erfolgt.

**5.** Verfahren nach einem der vorhergehenden Ansprüche, **dadurch gekennzeichnet, dass** der Laserstrahl mittels einem im Querschnitt quadratischen oder runden optischen Lichtleiter auf den Schichtenstapel (1) abgebildet wird.

**6.** Verfahren nach einem der vorhergehenden Ansprüche, **dadurch gekennzeichnet, dass** die optisch dichte Metallisierungsschicht (3) derart erwärmt wird, dass diese verdampft.

**7.** Verfahren nach einem der vorhergehenden Ansprüche, **dadurch gekennzeichnet, dass** eine Randentschichtung einer Solarzelle durchgeführt wird.

**8.** Verfahren nach einem der vorhergehenden Ansprüche, **dadurch gekennzeichnet, dass** eine Solarzellenstrukturierung durchgeführt wird.

**Claims**

**1.** Method for removing at least in certain areas at least one semiconductor layer (4) of a layer stack (1) made as CIS or CIGS, which has a semiconductor layer (4), an optically opaque metallisation layer (3) and on the side facing away from the semiconductor layer (4) if necessary one or several optically transparent layers (3), in which the optically opaque metallisation layer (3) is heated in such a way that the semiconductor layer lying above it is detached, in which the optically opaque metallisation layer (3) is heated by the side facing away from the semiconductor layer (4) if necessary through one or several optically transparent layers (2), in which heating is carried out by means of a laser (11, 18).

**2.** Method according to claim 1, **characterised in that** the optically opaque metallisation layer (3) is heated in such a way that at least one component of the semiconductor layer (4) lying over it, which has lower heat conductivity and/or a lower boiling point, evaporates.

**3.** Method according to one of the previous claims, **characterised in that** heating is carried out by means of an ns-laser (11, 18).

**4.** Method according to one of the previous claims, **characterised in that** heating is carried out by means of a pulsed laser (11, 18).

**5.** Method according to one of the previous claims, **characterised in that** the laser beam is formed on the layer stack (1) by means of an optical light guide with a square or round cross section.

**6.** Method according to one of the previous claims, **characterised in that** the optically opaque metallisation layer (3) is heated in such a way that it evaporates.

**7.** Method according to one of the previous claims, **characterised in that** edge deletion of a solar cell is carried out.

**8.** Method according to one of the previous claims, **characterised in that** solar cell structuring is carried out.

**Revendications**

**1.** Procédé d'enlèvement au moins par endroits d'au moins une couche semi-conductrice (4), constituée de CIS(séléniure de cuivre et d'indium) ou de CIGS( séléniure de cuivre, d'indium et de gallium) et faisant partie d'un empilement de couches (1) qui présente une couche semi-conductrice (4), une couche de métallisation (3) optiquement opaque et éventuellement une ou plusieurs couches de métallisation (2) optiquement transparentes sur le côté éloigné de la couche semi-conductrice, dans lequel la couche de métallisation (3) optiquement opaque est chauffée de telle sorte que la couche semi-conductrice située au-dessus est détachée, la couche de métallisation (3) optiquement opaque étant chauffée à partir du côté éloigné de la couche semi-conductrice (4) éventuellement à travers une ou plusieurs couches de métallisation (2) optiquement transparentes, l'échauffement étant effectué au moyen d'un laser (11, 18).

**2.** Procédé selon la revendication 1, **caractérisé en ce que** la couche de métallisation (3) optiquement opaque est chauffée de telle sorte qu'au moins un composant de la couche semi-conductrice située au dessus, et présentant une conductibilité thermique plus faible et/ou un point de fusion plus faible, s'évapore.

**3.** Procédé selon une des revendications précédentes, **caractérisé en ce que** l'échauffement est effectué au moyen d'un laser ns (11, 18).

**4.** Procédé selon une des revendications précédentes, **caractérisé en ce que** l'échauffement s'effectue au moyen d'un laser pulsé (11, 18).

5. Procédé selon une des revendications précédentes, **caractérisé en ce que** le faisceau laser est reproduit sur l'empilement de couches (1) au moyen d'un conduit de lumière optique de section transversale carrée ou ronde.

6. Procédé selon une des revendications précédentes, **caractérisé en ce que** la couche de métallisation (3) optiquement opaque est chauffée de telle sorte qu'elle s'évapore.

7. Procédé selon une des revendications précédentes, **caractérisé en ce qu'**il est effectué un enlèvement de couche en bordure d'une cellule solaire.

8. Procédé selon une des revendications précédentes, **caractérisé en ce qu'**il est effectué une structuration de cellule solaire.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19964443 B4
- EP 2083445 A1
- EP 1727211 A1
- DE 202008005970 U1

**In der Beschreibung aufgeführte Nicht-Patentliteratur**

- **QUERCIA L et al.** Laser patterning of CuInSe2/Mo/SLS structures for the fabrication of CuInSe2 sub modules. *Materials Science Forum,* 1995, vol. 173-174, 53-58
- Comparative investigation of solar cell thin film processing using nanosecond and femtosecond lasers; Solar cell thin film processing. **HERMANN J et al.** Journal of Physics D, Applied Physics. IOP Publishing, 07. Februar 2006, vol. 39, 453-460